# EUROPEAN PATENT SPECIFICATION

(11) **EP 1 624 312 B1**
(45) Date of publication and mention of the grant of the patent: **26.03.2008**
(21) Application number: 04425620.4
(22) Date of filing: 06.08.2004
(51) Int. Cl.: G01R 15/16

(54) **ELECTRONIC MEASUREMENT TRANSFORMER FOR COMBINED CURRENT AND VOLTAGE MEASUREMENTS.**
ELEKTRONISCHER MESSWANDLER ZU KOMBINIERTEN STROM- UND SPANNUNGSMESSUNGEN.
TRANSFORMATEUR DE MESURE ELECTRONIQUE POUR LA MESURE COMBINEE DES TENSIONS ET DES COURANTS.

(43) Date of publication of application: 08.02.2006
(73) Proprietor: Passoni & Villa Fabbrica Isolatori e Condensatori S.p.A., 20162 Milano (IT)
(72) Inventor: Villa, Giorgio, 20124 Milan (MI) (IT); Villa, Giancarlo, 20123 Milan (MI) (IT)
(74) Representative: Poulin, Gérard

(56) References cited:
- WO-A-20/04057346
- US-A- 3 942 099
- US-A- 5 272 460
- PATENT ABSTRACTS OF JAPAN vol. 2003, no. 12, 5 December 2003 (2003-12-05) & JP 2004 117310 A (TOSHIBA CORP), 15 April 2004 (2004-04-15)

## Description

The present invention relates to an electronic combined current and voltage measuring transformer (hereinafter "electronic combined current and voltage measuring device").

A first type of prior art electronic combined measuring device utilizes electro-optical transformers.

These devices measure the current by making use of magneto-optical effects and the voltage by making use of electro-optical effects, suitably transforming the electric signals coming from the network into optical signals to process and analyze them consequently.

In particular, the current transformers utilized therein operate making use of the "Faraday" effect.

According to the Faraday effect, a magnetic field influences the polarization of a ray of monochromatic light which passes through transparent optical means.

In the specific case, the magnetic field is produced by the current circulating on the line that passes through the transformer.

The light intensity is linked to the current value through a known mathematical relation.

Voltage transformers operate making use of the Pockels effect, according to which an electric field is capable of influencing the optical behavior, in particular, the refraction index of a crystal through which a light ray passes.

In the specific case the electric field will be proportional to the voltage of the power line.

Also in this case there is a known mathematical relation between the light intensity and the voltage value.

This type of prior art device has been employed experimentally on a limited number of transformers.

A barrier for placing these combined measuring devices on the market is without doubt represented by the production costs, which can be compared to those of traditional transformers with consolidated reliability.

A second type of classic prior art combined measuring device is constituted by an inductive transformer to measure voltage, generally fitted on the head of a current transformer and having isolation to ground in common therewith.

In current transformers employed to produce the aforesaid combined measuring devices, the primary winding is constituted by one of the conductors of the power line while the secondary windings, suitably insulated, are constituted by coils wound on toroidal magnetic cores.

Insulation between the primary and secondary winding is generally produced by means of pressurized gas or oil/paper.

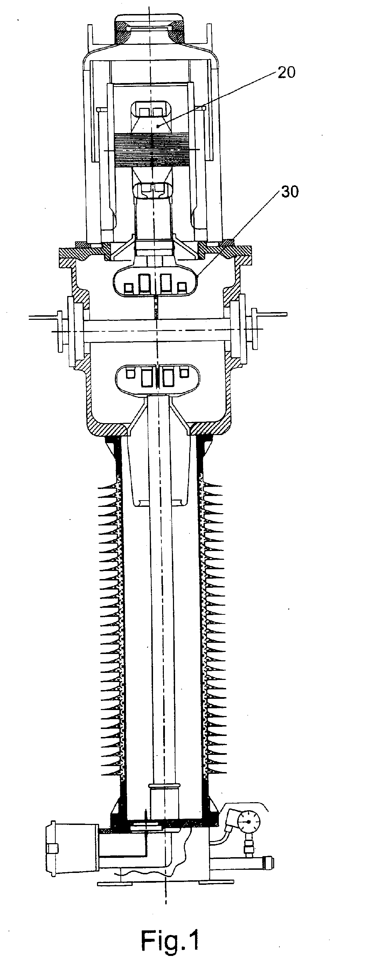

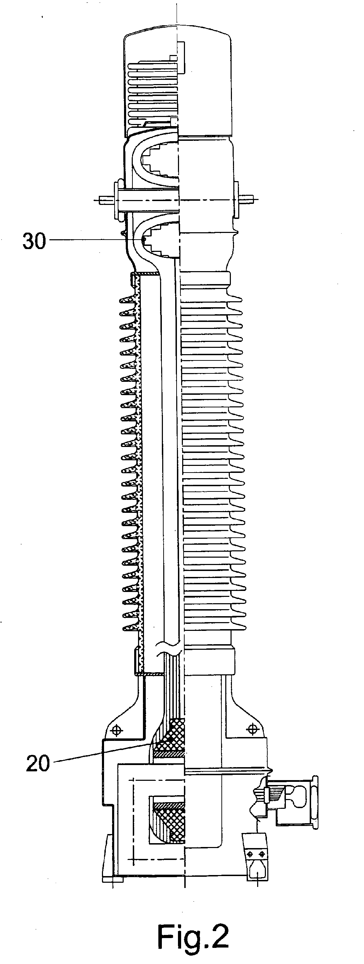

The second type of classic prior art combined measuring device is shown schematically in Figures 1 and 2.

Figure 1 shows, by way of an example, a combined measuring device in the case in which insulation is produced with pressurized gas; in this configuration an inductive transformer (20) is inserted on the head of a current transformer (30).

Figure 2 instead shows a combined measuring device wherein the insulation means is constituted by oil/paper; in this configuration the inductive transformer (20) for voltage measurement may generally be positioned in the lower part of the body of the combined device.

Devices belonging to said second type of classic combined measuring devices have the following weak points:
- all inductive transformers are "easily saturable" and therefore in the case of overcurrents/overvoltages the measurement and protection signals are distorted with the possibility of dangerous ferro-resonance effects;
- combined devices are very heavy with consequent problems of transport, assembly and during operation in concurrence with seismic phenomena, as the most important masses are positioned in the upper part of the object;
- the decrease in costs with respect to the sum of the two transformers considered separately is insignificant and only justifies their use in specific markets where reducing spaces is a priority.

Document D1 (JP 2004 117310) discloses a compound transformer for current and voltage measurement. The current measuring system is composed by an optical sensor system (2), placed inside the metal vessel (3), that transmits the digital current signal, via optic fiber, inside the supporting metal tube (4) at H.V. potential.

This is system of the type already described in the first type of prior art, one that makes use of the Faraday effect or analogous magneto optical effect.

The voltage signal is taken off from a capacitive divider where the H.V. arm consists of the capacitance between the capacitor bushing (8), insulated from the ground for the full voltage by a post insulator, and the electrode (9), and the low voltage arm consists of an industrial capacitor (10), placed outside the ground vessel (7).

Document D2 (US 5.272,460) discloses a current and voltage transformer intended for a metal-encapsulated, gas insulated high-voltage installation only.

The arrangement of the current and voltage sensor is facilitated by the presence of the metal duct because they are placed in an environment at low voltage potential.

The object of the present invention is to solve the aforesaid problems by producing an electronic combined current and voltage measuring device that makes both the voltage and the current analog signals available directly in Low Voltage, without the need for complicated power supplies of the current and voltage transducers in High Voltage.

A further object of the present invention is to produce an electronic combined current and voltage measuring device with reduced dimensions, decreased weight, and which is much more reliable in the case of transient state, better withstands seismic stresses and is practically not sensitive to frequency variation in a very wide range.

The final object of the present invention is to produce an electronic combined current and voltage measuring device with reduced costs and which is easily serviced.

These objects are attained by an electronic combined current and voltage measuring device, as claimed in claim 1, which should be referred to for brevity.

The invention is described in detail hereunder, by way of a non-limiting example, with reference to the accompanying drawings, wherein:
- Figure 1 shows a sectional view of a combined current and voltage measuring device, according to a first prior art type;
- Figure 2 shows a sectional view of a combined current and voltage measuring device, according to a second prior art type;

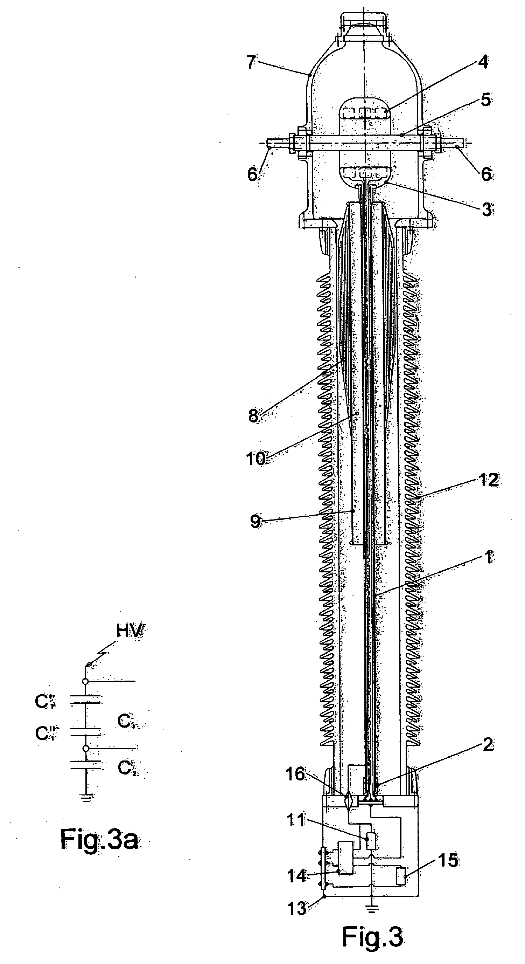

- Figure 3 shows a sectional view of a first embodiment of the electronic combined current and voltage measuring device according to the present invention;
- Figure 3a shows the electric diagram of the voltage measurement system of the electronic combined measuring device shown in Figure 3;

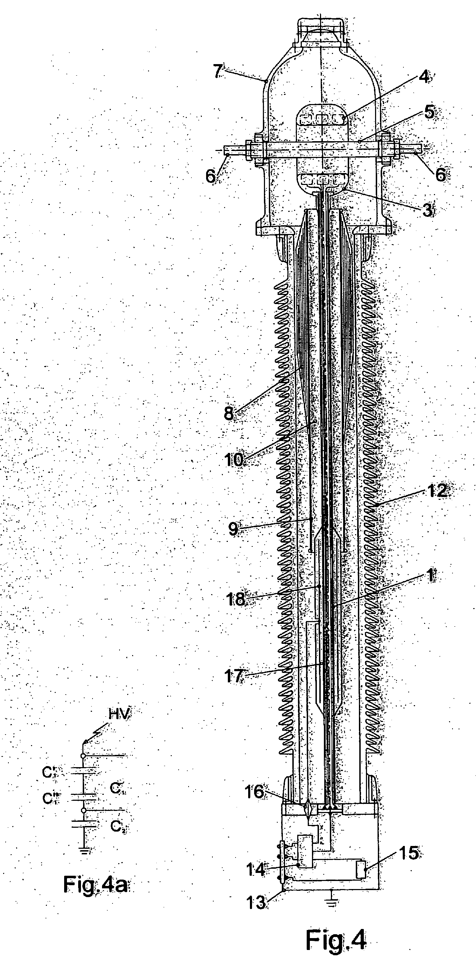

- Figure 4 shows a sectional view of a second embodiment of the electronic combined current and voltage measuring device according to the present invention;
- Figure 4a shows the electric diagram of the voltage measurement system shown in figure 4;

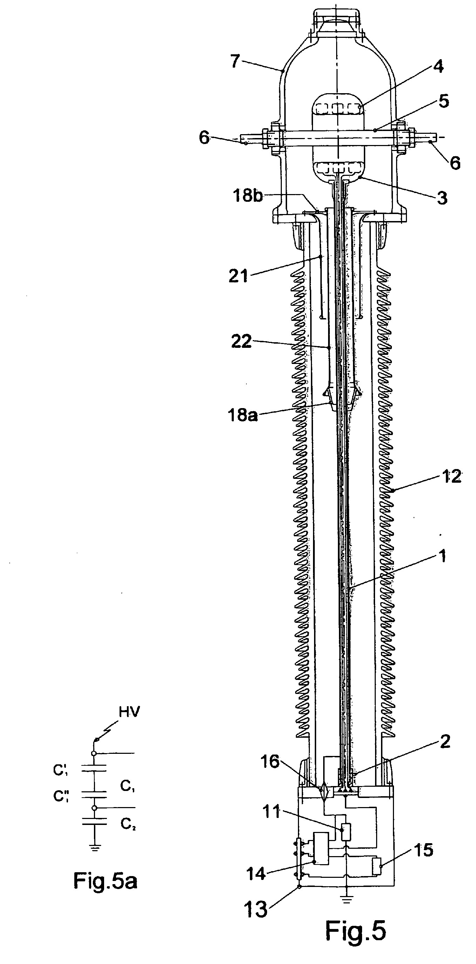

- Figure 5 shows a sectional view of a third embodiment of the electronic combined current and voltage measuring device according to the present invention;
- Figure 5a shows the electric diagram of the voltage measurement system shown in figure 5;

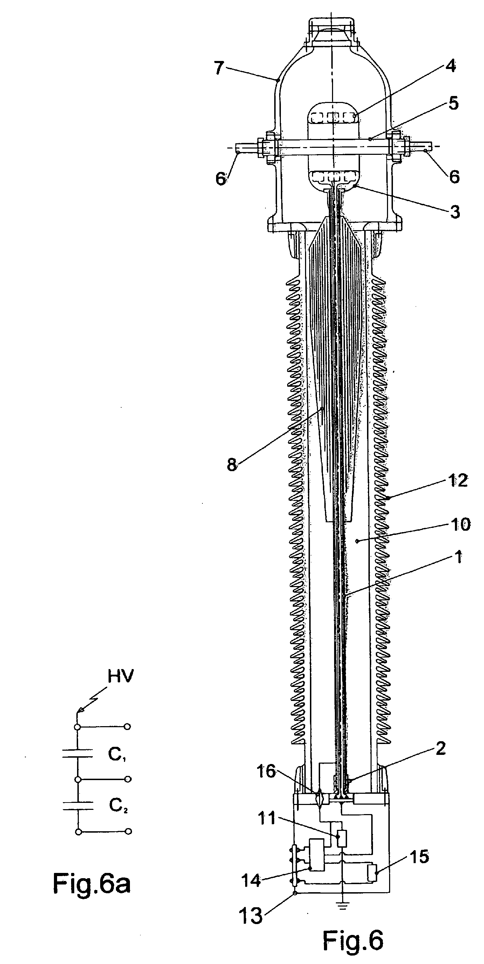

- Figure 6 shows a sectional view of a fourth embodiment of the electronic combined current and voltage measuring device according to the present invention; and
- Figure 6a shows the electric diagram of the voltage measurement system shown in figure 6.

The electronic combined measuring device of the present invention is indicated as a whole, in an exemplifying embodiment, in Figures 3 and 3a.

The electronic combined measuring device has a base (13), connected to which is an insulating body (12) that supports a cap (7) at H.V. potential passing through which is a primary conductor (5), connected in series to a High Voltage power line by means of terminals (6).

Said cap (7) contains a metal shell (3) supported at the bottom by a metal tube (1), at potential, very close to ground potential, which is coaxial to said insulating body (12) and fixed to the base (13) by means of a L.V. insulator (2) which insulates it from ground for a very low voltage (max 10 V).

One or more Rogowsky coils (4), of active or passive type, are placed inside the shell (3).

The insulation between the shell (3) at a potential very close to ground potential, and the elements consisting of primary conductor (5), the terminals (6) and the cap (7), at H.V. potential, is generally constituted by pressurized insulating gas, the same gas existing in the part (10), delimited by the insulating body (12), where a voltage divider is provided for the purpose of voltage measurement and protection.

This voltage divider is formed by the series of two capacitances C₁ and C₂ where C₁ is composed by the capacitance C₁, of the capacitor bushing (8), wound on the electrode (9), and the capacitance C_{1"} formed by the same electrode (9), and the tube (1), and C₂ is the capacitance of a capacitor (11) in series to the ground (Figure 3a).

The low voltage, proportional to the H.V. value of the voltage to be measured or to be used for protection purpose, is drawn from the tube 1 to be sent to a converter (14) through a plug (16) (Fig.3).

The current signal, proportional to the current value to be measured in the H.V. line or to be used as overcurrent protection, is produced by means of the Rogowsky coils (4) and sent through the L.V. insulated wires, placed inside the tube (1) at potential very close to ground potential, to the converter (14).

Inside said converter (14), fed by a L.V. power supply (15), powered by the L.V. mains of the Power Station or Substation, the analogue current and voltage signals are converted into digital ones, then transformed in light signals and subsequently sent, by means of optical fibers, to the electronic measurements and protection devices located in the control room of the Power Station or Substation.

The signals are then reconstructed by opto-electric demodulators and, if necessary, through digital-analogue converters.

Finally, the capacitor bushing (8) has the further function to uniformly distribute the voltage either longitudinally on the insulating body (12) or radially inside the same insulating body (12).

According to a second embodiment of the present invention shown in Figures 4 and 4a, the capacitance C₁ is composed by two series capacitances C₁', formed by the capacitance of the capacitor bushing (8), and C₁" formed by the capacitance between the electrode (9) and the tube (1), and capacitance C₂ is represented by low voltage capacitance of a metallic foil (18) towards the tube (1), duly insulated to ground by a low voltage insulation (17).

The low voltage, proportional to the H.V. value to be measured is drawn from the metallic foil (18) through the plug and sent to the converter (14).

According to a third embodiment of the present invention shown in Figures 5 and 5a, the capacitance C₁ is constituted by a series of suitable metal electrodes (21) and (22), forming the capacitance C₁, and C_{1"}, insulated between each other for example by gas and supported by insulating spacing blocks (18a) and (18b).

The capacitance C₂ of the divider is composed by the low voltage capacitor (11) connected at one side to the tube, duly insulated for low voltage, and at the other side to the ground.

According to a fourth embodiment of the present invention shown in Figures 6 and 6a, the capacitance C₁ is constituted by the series of metallic foils of the capacitor bushing (8) wound on the tube (1) and insulated from the ground by a L.V. insulator (2) (max 10 V) and C₂ is the capacitance of the capacitor (11) put in series between the tube (1) and the ground through the plug (16).

The combined measuring device may use pressurized gas - typically SF6 - as insulating means, or other dielectric fluids such as mineral or synthetic oils.

The voltage and current signals are available, with degree of accuracy definable in a preestablished frequency range, for possible measurement of their harmonic content.

The Rogowsky coils may be of the passive type and consequently in this case they do not require an external power supply.

The electronic combined voltage and current measuring device of the present invention has numerous and important advantages with respect to devices utilized in prior art.

In the first place, with the aforesaid device, the analogue signals are made available directly in L.V. and sophisticated magneto or electro-optical transducers in H.V. side are not required.

In addition, the voltage signals are modulated and converted from analogue to digital signals, then transformed into light signals by an electro-optical transmitter in a simple and reliable way. The optical fibers can transmit the signals to a certain distance with perfect galvanic isolation. The signals are reconstructed passing through an opto-electronic converter and, if necessary, through a digital-analogue converter.

Finally, this highly reliable device is obtainable at moderate costs.

From the description hereinbefore it is apparent that the inventive concepts expressed are not limited to the applicative examples illustrated, but they may be advantageously adapted to other analogous applications.

The field of use of the present invention is not limited to the examples indicated in the description hereinbefore.

The present invention is therefore susceptible to numerous modifications and variants all coming within the inventive concept expressed in the claims.

## Claims

1. Electronic combined current and voltage measuring device, comprising a metallic tube (1), at potential very close to ground potential, which supports a metal shell (3) to contain Rogowsky coils (4) and to allow the passage of a primary conductor (5) connected to the high voltage line by means of terminals (6) fixed to a cap (7) as well as an insulating body (12) within which the metallic tube (1) is arranged and surrounded by metal foils of a capacitor bushing (8) wound around an electrode (9) surrounding said tube (1), and a power supply (15), wherein the insulation between said metal shell (3), at potential very close to ground potential, and the elements at H.V. potential, consisting of said primary conductor (5), said terminal (6) and said cap (7), is generally guaranteed by pressurized insulating gas, the same gas existing in a part (10), delimited by said insulating body (12), where a voltage divider, formed by the series of two capacitances C₁ and C₂, gives a L.V. signal proportional to high voltage value to be measured and where the analogue current signal, proportional to the current value in H.V. side to be measured, obtained by said Rogowsky coils (4) and transmitted by L.V. insulated cables, inside said tube (1), both signals being sent into a converter (14), fed by said power supply (15) connected to the L.V. mains of the Power Station or Substation, and converted from analogue to digital signals and then to optical signals to be transmitted, via optical fibers, to electronic and protection devices, located in the control room of the Power Station or Substation, for measuring and protection purposes, after opto-electric conversion.

2. Combined measuring device as claimed in claim 1, **characterized in that** C₁ is composed by the capacitance C₁, of said capacitor bushing (8), wound on said electrode (9) and by the capacitance C_{1"} formed by the said electrode (9) and said tube (1), and C₂, is the capacitance of a capacitor (11) put in series to ground.

3. Combined measuring device as claimed in claim 1, **characterized in that** the capacitance C₁ is composed by two series capacitances C₁', formed by the capacitance of said capacitor bushing (8), and C₁" formed by the capacitance between said electrode (9) and said tube (1), and capacitance C₂ is represented by low voltage capacitance of a metallic foil (18) towards said tube (1), duly insulated to ground by a low voltage insulation (17), the low voltage, proportional to the H.V. value to be measured being drawn from said metallic foil (18) through a plug (16) and sent to said converter (14).

4. Combined measuring device as claimed in claim 1, **characterized in that** the capacitance C₁ is constituted by the series of suitable metal electrodes (21 and 22), forming the capacitance C₁, and C_{1"}, insulated between each other for example by gas and supported by insulating spacing blocks (18a and 18b), the capacitance C₂ of the divider being formed by a low voltage capacitor (11) connected at one side to the tube, duly insulated for low voltage, and at the other side to the ground.

5. Combined measuring device as claimed in claim 1, **characterized in that** the capacitance C₁ is constituted by the series of metallic foils of the capacitor bushing (8) wound on said tube (1) and insulated from the ground by a L.V. insulator (2) (max 10 V), and C₂ is the capacitance of the capacitor (11) put in series between the tube (1) and the ground through a plug (16).

## Patentansprüche

1. Elektronische kombinierte Strom- und Spannungsmeßvorrichtung, umfassend ein metallisches Rohr (1) unter einer Spannung, die sehr nahe dem Erdpotential ist, welches Rohr eine Metallhülse (3) trägt, die Rogowsky-Spulen (4) enthält und den Durchgang eines Primärleiters (5) ermöglicht, der mit der Hochspannungsleitung mit Hilfe von Klemmen (6) verbunden ist, die an einer Haube (7) sowie einem Isolierkörper (12) festliegen, in dem das metallische Rohr (1) angeordnet ist und von Metallfolien einer Kondensatorbüchse (8) umgeben ist, welche rund um eine Elektrode (9) gewickelt sind, die das Rohr (1) umgibt, und ferner umfassend eine Spannungsquelle (15), wobei die Isolierung zwischen der Metallhülse (3), unter einer Spannung sehr nahe der Erdspannung, und den Elementen unter einem Hochspannungspotential, bestehend aus dem genannten Primärleiter (5), der genannten Anschlußklemme (6) und der genannten Haube (7), durch ein unter Druck stehendes Isoliergas gewährleistet wird und dasselbe Gas in einem Teil (10), abgegrenzt von dem Isolierkörper (12), vorhanden ist, wobei ein Spannungsteiler, bestehend aus zwei in Reihe geschalteten Kapazitäten C₁ und C₂, ein Niederspannungssignal erzeugt, das proportional dem zu messenden Hochspannungswert ist, und wobei ferner das analoge Stromsignal, das proportional dem zu messenden Stromwert auf der Hochspannungsseite ist, durch die genannten Rogowsky-Spulen (4) erhalten und durch isolierte Niederspannungskabel innerhalb des Rohres (1) übertragen wird, wobei darüber hinaus beide Signale in einen Umsetzer (14) geschickt werden, der von der Stromquelle (15) gespeist wird, die mit dem Niederspannungsnetz der Netzstation oder -unterstation verbunden ist und von analogen in digitale Signale verwandelt werden und danach in optische Signale, die über Glasfasern auf elektronische und Schutzeinrichtungen übertragen werden, welche in dem Steuerraum der Netzstation oder -unterstation angeordnet sind, und zwar zu Messungs- und Schutzzwecken nach der opto-elektrischen Umwandlung.

2. Kombinierte Meßvorrichtung nach Anspruch 1, **dadurch gekennzeichnet, daß** C₁ aus dem Kondensator C₁ der Kondensatorhülse (8) zusammengesetzt ist, der auf die Elektrode (9) aufgewickelt ist, sowie aus dem Kondensator C₁, der von der Elektrode (9) und dem Rohr (1) gebildet wird, wobei C₂ die Kapazität eines Kondensators (11) ist, der mit der Erde in Reihe geschaltet ist.

3. Kombinierte Meßvorrichtung nach Anspruch 1, **dadurch gekennzeichnet, daß** die Kapazität C₁ aus in Reihe liegenden Kapazitäten C₁' zusammengesetzt ist, die von der Kapazität der Kondensatorhülse (8) gebildet werden sowie C₁", gebildet von der Kapazität zwischen der Elektrode (9) und dem Rohr (1), wobei die Kapazität C₂ von der Niedrigspannungskapazität einer metallischen Folie (18) in Bezug auf das Rohr (1) gebildet wird, das in geeigneter Weise gegenüber der Erde durch eine Niedrigspannungsisolierung (17) isoliert ist, und wobei die Niedrigspannung proportional dem zu messenden Hochspannungswert von der metallischen Folie (18) durch einen Stecker (16) abgeleitet und dem Umsetzer (14) zugeführt wird.

4. Kombinierte Meßvorrichtung nach Anspruch 1, **dadurch gekennzeichnet, daß** die Kapazität C₁ von der Reihe geeigneter Metallelektroden (2 und 22) gebildet wird, die die Kapazität C₁' und C₁" haben, welche voneinander beispielsweise durch Gas isoliert werden und durch isolierende Abstandsblöcke (18a und 18b) getragen werden, wobei die Kapazität C₂ des Teilers von einem Niederspannungskondensator (11) gebildet wird, der einerseits an dem Rohr angeschlossen ist, das in geeigneter Weise niederspannungsisoliert ist, und andererseits gegen die Erde isoliert ist.

5. Kombinierte Meßvorrichtung nach Anspruch 1, **dadurch gekennzeichnet, daß** die Kapazität C₁ von der Reihe metallischer Folien der Kondensatorhülse (8) gebildet wird, die auf das Rohr (1) aufgewickelt sind und gegenüber der Erde durch einen Niederspannungsisolator (2) (maximal 10 V) isoliert sind, und daß C₂ die Kapazität des Kondensators (11) ist, der zwischen dem Rohr (1) und der Erde durch einen Stecker (16) in Reihe geschaltet ist.

## Revendications

1. Dispositif de mesure électronique combiné de courant et de tension, comprenant un tube métallique (1), ayant un potentiel très proche du potentiel de mise à la terre, qui supporte une enveloppe métallique (3) pour contenir des bobines de Rogowsky (4) et pour permettre le passage d'un conducteur primaire (5) relié à la ligne de haute tension au moyen de bornes (6) fixées sur un couvercle (7) ainsi qu'un corps d'isolation (12) à l'intérieur duquel le tube métallique (1) est disposé et entouré de feuilles métalliques d'une traversée à condensateurs (8) enroulée autour d'une électrode (9) entourant ledit tube (1), et une alimentation électrique (15), dans laquelle l'isolation entre ladite enveloppe métallique (3), ayant un potentiel très proche du potentiel de mise à la terre, et les éléments ayant un potentiel de haute tension, constitué dudit conducteur primaire (5), de ladite borne (6) et dudit couvercle (7), est généralement assurée par un gaz pressurisé d'isolation, le même gaz existant dans une partie (10), délimitée par ledit corps d'isolation (12), où un diviseur de tension, formé par la suite de deux capacités C₁ et C₂, fournit un signal de basse tension proportionnel à une valeur de haute tension à mesurer et où le signal de courant analogique, proportionnel à la valeur du courant au niveau du côté de haute tension à mesurer, est obtenu par lesdites bobines de Rogowsky (4) et transmis par des câbles isolés de basse tension, à l'intérieur dudit tube (1), les deux signaux étant envoyés dans un convertisseur (14), alimenté par ladite alimentation électrique (15) reliée aux conducteurs principaux de basse tension de la station électrique principale ou de la station électrique secondaire, et convertis de signaux analogiques en signaux numériques et ensuite en signaux optiques à transmettre, par l'intermédiaire de fibres optiques, à des dispositifs électroniques et de protection, situés dans la chambre de commande de la station électrique principale ou de la station électrique secondaire, à des fins de mesure et de protection, après la conversion optique-électrique.

2. Dispositif de mesure combiné selon la revendication 1, **caractérisé en ce que** C₁ est composée de la capacité C₁, de ladite traversée à condensateurs (8), enroulée sur ladite électrode (9) et de la capacité C_{1"} formée par ladite électrode (9) et ledit tube (1), et C₂, correspond à la capacité d'un condensateur (11) mis en série à la terre.

3. Dispositif de mesure combiné selon la revendication 1, **caractérisé en ce que** la capacité C₁ est composée de deux capacités en série C_{1'}, formées par la capacité de ladite traversée à condensateurs (8), et C_{1"} formée par la capacité entre ladite électrode (9) et ledit tube (1), et la capacité C₂ est représentée par une capacité de basse tension d'une feuille métallique (18) vers ledit tube (1), correctement isolée à la terre par une isolation de basse tension (17), la basse tension, proportionnelle à la valeur de haute tension à mesurer étant acheminée depuis ladite feuille métallique (18) à travers une fiche (16) et envoyée audit convertisseur (14).

4. Dispositif de mesure combiné selon la revendication 1, **caractérisé en ce que** la capacité C₁ est constituée d'une série d'électrodes métalliques appropriées (21 et 22), formant la capacité C_{1'} et C_{1"}, isolées l'une de l'autre par exemple par un gaz et supportées par des blocs d'espacement d'isolation (18a et 18b), la capacité C₂ du diviseur étant formée par un condensateur de basse tension (11) relié au niveau d'un côté au tube, correctement isolé pour une basse tension, et au niveau de l'autre côté à la terre.

5. Dispositif de mesure combiné selon la revendication 1, **caractérisé en ce que** la capacité C₁ est constituée de la série de feuilles métalliques de la traversée à condensateurs (8) enroulée sur ledit tube (1) et isolée de la terre par un isolateur de basse tension (2) (max 10 V), et C₂ correspond à la capacité du condensateur (11) disposé en série entre le tube (1) et la terre à travers une fiche (16).
